# EUROPEAN PATENT SPECIFICATION

(11) **EP 1 364 392 B1**
(45) Date of publication and mention of the grant of the patent: **12.04.2006**
(21) Application number: 02716203.1
(22) Date of filing: 01.02.2002
(51) Int. Cl.: H01L 21/18, H01L 33/00, H01S 5/026

(54) **METHOD OF MANUFACTURING OPTICAL DEVICES AND RELATED IMPROVEMENTS**
HERSTELLUNGSVERFAHREN FÜR OPTISCHE VORRICHTUNGEN UND VERBESSERUNGEN
PROCEDE DE FABRICATION DE DISPOSITIFS OPTIQUES ET AMELIORATIONS ASSOCIEES

(30) Priority: 01.02.2001 GB 0102536
(43) Date of publication of application: 26.11.2003
(73) Proprietor: THE UNIVERSITY COURT OF THE UNIVERSITY OF GLASGOW, Glasgow G12 8QQ (GB)
(72) Inventor: MARSH, John, Haig, Glasgow G12 OSN (GB); MCDOUGALL, Stewart, Duncan, North Kelvinside, Glasgow G2 6DF (GB); HAMILTON, Craig, James, Bishopton, Renfrewshire PA7 5LT (GB); KOWALSKI, Olek, Peter, Paisley PA1 3JN (GB)
(74) Representative: Charig, Raymond Julian
(86) International application number: PCT/GB2002/000445
(87) International publication number: WO 2002/061814

(56) References cited:
- WO-A-02/059952
- US-A- 5 879 519
- KOWALSKI O P, HAMILTON C J, MCDOUGALL S D, MARSH J H, BRYCE A C, DE LA RUE R M, VÖGELE B, STANLEY C R, BUTTON C C ROBERTS J S: "A universal damage induced technique for quantum well intermixing" APPLIED PHYSICS LETTERS, vol. 72, no. 5, 2 February 1998 (1998-02-02), pages 581-583, XP002247336 USA
- MCDOUGALL S D, KOWALSKI O P, HAMILTON C J, CAMACHO F, QIU B, KE M, DE LA RUE R M, BRYCE A C, MARSH J H: "Monolithic Integration via a universal damage enhanced quantum-well intermixing technique" IEEE JOURNAL OF SELECTED TOPICS IN QUANTUM ELECTRONICS, vol. 4, no. 4, July 1998 (1998-07) - August 1998 (1998-08), pages 636-646, XP002247338 USA
- QIU B C ET AL: "Extended cavity lasers in InGaAs-InGaAsP and InGaAlP-GaAs multi-quantum well structure using a sputtered SiO2 technique" INDIUM PHOSPHIDE AND RELATED MATERIALS, 1998 INTERNATIONAL CONFERENCE ON TSUKUBA, JAPAN 11-15 MAY 1998, NEW YORK, NY, USA,IEEE, US, 11 May 1998 (1998-05-11), pages 635-638, XP010295393 ISBN: 0-7803-4220-8
- QIU B C, KE M L, KOWALSKI O P, BRYCE A C, AITCHISON J S, MARSH J H, OWEN M, WHITE I H, PENTY R V: "Monolithically integrated fabrication of 2x2 and 4x4 crosspoint switches using quantum well intermixing" CONFERENCE PROCEEDINGS. 2000 INTERNATIONAL CONFERENCE ON INDIUM PHOSPHIDE AND RELATED MATERIALS, WILLIAMSBURG, VA, USA, 14 - 18 May 2000, pages 415-418, XP002248744 Piscataway, NJ, USA
- LIU X F ET AL: "CONTROL OF MULTIPLE BANDGAP SHIFTS IN INGAAS-ALINGAAS MULTIPLE-QUANTUM-WELL MATERIAL USING DIFFERENT THICKNESSES OF PECVDSIO2 PROTECTION LAYERS" IEEE PHOTONICS TECHNOLOGY LETTERS, IEEE INC. NEW YORK, US, vol. 12, no. 9, September 2000 (2000-09), pages 1141-1143, XP000968625 ISSN: 1041-1135
- QIU B C, LIU X F, KOWALSKI O P, BRYCE A C, MARSH J H: "Precise control of the blue-shift of the wavelength in InGaAs-InGaAsP multiple quantum wells using a sputtered SiO2 technique" 1999 IEEE LEOS ANNUAL MEETING CONFERENCE PROCEEDINGS, 12TH ANNUAL MEETING, SAN FRANCISCO, CA, USA, vol. 1, 8 - 11 November 1999, pages 309-310, XP002248745 Piscataway, NJ, USA

## Description

### FIELD OF INVENTION

This invention relates to a method of manufacturing of optical devices, and in particular, though not exclusively, to manufacturing integrated optical devices or optoelectronic devices, for example, semiconductor optoelectronic devices such as laser diodes, optical modulators, optical amplifiers, optical switches, optical detectors, and the like. The invention further relates to Optoelectronic Integrated Circuits (OEICs) and Photonic Integrated Circuits (PICs) including such devices.

### BACKGROUND TO INVENTION

Quantum Well Intermixing (QWI) is a process which has been reported as providing a possible route to monolithic optoelectronic integration. QWI may be performed in III-V semiconductor materials, eg Aluminium Gallium Arsenide (AlGaAs) and Indium Gallium Arsenide Phosphide (InGaAsP), which may be grown on binary substrates, eg Gallium Arsenide (GaAs) or Indium Phosphide (InP). QWI alters the band-gap of an as-grown structure through interdiffusion of elements of a Quantum Well (QW) and associated barriers to produce an alloy of the constituent components. The alloy has a band-gap which is larger than that of the as-grown QW. Any optical radiation (light) generated within the QW where no QWI has taken place can therefore pass through a QWI or "intermixed" region of alloy which is effectively transparent to the said optical radiation.

Various QWI techniques have been reported in the literature. For example, QWI can be performed by high temperature diffusion of elements such as Zinc into a semiconductor material including a QW.

QWI can also be performed by implantation of elements such as silicon into a QW semiconductor material. In such a technique the implantation element introduces point defects in the structure of the semiconductor material which are moved through the semiconductor material inducing intermixing in the QW structure by a high temperature annealing step.

Such QWI techniques have been reported in "Applications of Neutral Impurity Disordering in Fabricating Low-Loss Optical Waveguides and Integrated Waveguide Devices", Marsh *et al*, Optical and Quantum Electronics, 23, 1991, s941 - s957.

A problem exists with such techniques in that although the QWI will alter (increase) the band-gap of the semiconductor material post-growth, residual diffusion or implantation dopants can introduce large losses due to the free carrier absorption coefficient of these dopant elements.

A further reported QWI technique providing intermixing is Impurity Free Vacancy Diffusion (IFVD). When performing IFVD the top cap layer of the III-V semiconductor structure is typically GaAs or Indium Gallium Arsenide (InGaAs). Upon the top layer is deposited a silica (SiO₂) film. Subsequent rapid thermal annealing of the semiconductor material causes bonds to break within the semiconductor alloy and Gallium ions or atoms - which are susceptible to silica (SiO₂) - to dissolve into the silica so as to leave vacancies in the cap layer. The vacancies then diffuse through the semiconductor structure inducing layer intermixing, eg in the QW structure.

IFVD has been reported in "Quantitative Model for the Kinetics of Compositional Intermixing in GaAs-AlGaAs Quantum-Confined Heterostructures", by Helmy *et al*, IEEE Journal of Selected Topics in Quantum Electronics, Vol 4, No 4, July/August 1998, pp 653 - 660.

A QWI technique involving the deposition of a thin layer of sputtered SiO₂ and a subsequent high temperature anneal is disclosed in "A universal damage induced technique for quantum well intermixing" by Kowalski et al., Applied Physics Letters, Vol. 72, No. 5, 2 February 1998, pages 581-583.

It is an object of at least one aspect of the present invention to obviate or at least mitigate at least one of the aforementioned disadvantages/problems in the prior art.

It is also an object of at least one aspect of the present invention to provide an improved method of manufacturing an optical device using an improved QWI process.

### SUMMARY OF INVENTION

The present invention is defined in claim 1.

According to the present invention, there is provided a method of manufacturing an optical device, a device body portion from which the device is to be made including a Quantum Well (QW) structure, the method including the step of processing the device body portion so as to create extended defects at least in a portion of the device portion.

Each extended defect may be understood to be a structural defect comprising a plurality of adjacent "point" defects.

Said step of processing the device body portion comprises performing a plasma etch on the device body portion. Preferably and advantageously the said step of performing a plasma etch on the device body portion may be performed in a sputterer. In said step of sputtering from the device body portion a magnetic field may be provided around the device body portion. In said step of sputtering from the device body portion, a magnetron sputterer may be used.

In said step of performing a sputter etch on the device body portion a (reverse) electrical bias may be applied across an electrode upon which the device body portion is provided so as to provide a "pre-etch" or cleansing of the device body portion. Preferably the sputter-etch is carried out for between 0.5 and 10 minutes at a power between 300 and 750 W, at a sputter pressure between 1 and 5 µm Hg (0.1 and 0.7 Pa).

The method may include the preferred step of depositing a dielectric layer on at least one other portion of the device body portion. The dielectric layer may therefore act as a mask in defining the at least one portion. The method may also include the subsequent step of depositing a further dielectric layer on the dielectric layer and/or on the at least one portion of the device body portion.

Advantageously the dielectric layer and/or further dielectric layer may be deposited by use of a sputterer. Alternatively, the dielectric layer and/or the further dielectric layer may be deposited by a deposition technique other than by use of a sputterer, eg Plasma Enhanced Chemical Vapour Deposition (PECVD). By either of these deposition techniques at least one low damage dielectric layers is provided which does not substantially affect an adjacent portion of the device body portion.

The dielectric layer or layers may beneficially substantially comprise silica (SiO₂); or may comprise another dielectric material such as Aluminium Oxide (Al₂O₃).

Preferably, the sputterer includes a chamber which may be substantially filled with an inert gas such as argon, preferably at a pressure of around 2 microns of Hg (0.3 Pa) or a mixture of argon and oxygen, eg in the proportion 90% /10%.

The step(s) of depositing the dielectric layer(s) may comprise part of a Quantum Well Intermixing (QWI) process used in manufacture of the device. The QWI process may comprise Impurity-Free Vacancy Disordering (IFVD).

Preferably, the method of manufacture also includes the subsequent step of annealing the device body portion including the dielectric layer at an elevated temperature.

It has been surprisingly found that by performing the plasma etch on the device body portion as a step in a QWI technique such as IFVD, preferably by use of a sputterer, damage induced extended defects appear to be introduced into the at least one portion of the device body portion; the at least one portion may, for example, comprise at least a part of a top or "capping" layer. It is believed that the damage arises due to breakage of bonds in the capping layer before annealing, eg the application of thermal energy by rapid thermal annealing, thereby inhibiting transfer of Gallium from the at least one portion, eg into the further dielectric layer.

Preferably the method of manufacture also includes the preceding steps of:
providing a substrate;
growing on the substrate:
   a first optical cladding layer;
   a core guiding layer including a Quantum Well (QW) structure; and
   a second optical cladding layer.

The first optical cladding layer, core guiding layer, and second optical cladding layer may be grown by Molecular Beam Epitaxy (MBE) or Metal Organic Chemical Vapour Deposition (MOCVD).

In a preferred embodiment the method may comprise the steps of:
depositing the dielectric layer on a surface of the device body portion;
defining a pattern in photoresist on a surface of the dielectric layer and lifting off at least part of the photoresist so as to provide the dielectric layer on said at least one other portion of the device body portion.

In said preferred embodiment, the method may also include the step of depositing the further dielectric layer on a portion of the surface of the device body and on a surface of the dielectric layer prior to annealing.

In said preferred embodiment, the dielectric layer may comprise an intermixing cap; while the at least one portion of the device body portion and/or the further dielectric layer may comprise an intermixing suppressing cap. The thickness of the dielectric layer(s) may be between 10 and 1000 nm. More preferably, the thickness of the dielectric layers may be 200 or 300 nm.

A subsequent annealing step may occur at a temperature of between 700 and 1000°C for between 0.5 and 5 minutes, more preferably between 800 and 1000°C and in one embodiment at substantially 900°C for around 1 minute.

According to a first example not forming part of the present invention there is provided a method of manufacturing an optical device, a device body portion from which the device is to be made including a Quantum Well (QW) structure, the method including the step of performing a plasma etch on the device body portion. Preferably the step of performing a plasma etch on the device body portion is carried out using a sputterer.

According to a second example not forming part of the present invention there is provided an optical device fabricated from a method according to either the present invention or the first example. The optical device may be an integrated optical device or an optoelectronic device.

The device body portion may be fabricated in a III-V semiconductor materials system. In a most preferred embodiment the III-V semiconductor materials system may be a Gallium Arsenide (GaAs) based system, and may operate at a wavelength(s) of substantially between 600 and 1300 nm. Alternatively, the III-V semiconductor materials system may be an Indium Phosphide based system, and may operate at a wavelength(s) of substantially between 1200 and 1700 nm. The device body portion may be made at least partly from Aluminium Gallium Arsenide (AlGaAs) and / or Indium Gallium Arsenide (InGaAs), Indium Gallium Arsenide Phosphide (InGaAsP), Indium Gallium Aluminium Arsenide (InGaAlAs) and/or Indium Gallium Aluminium Phosphide (InGaAlP).

The device body portion may comprise a substrate upon which are provided a first optical cladding layer, a core guiding layer, and a second optical cladding layer. Preferably the Quantum Well (QW) structure is provided within the core guiding layer. The core guiding layer, as grown, may have a smaller band-gap and higher refractive index than the first and second optical cladding layers.

According to a third example not forming part of the present invention there is provided an optical integrated circuit, optoelectronic integrated circuit (OEIC), or photonic integrated circuit (PIC) including at least one optical device according to the second example.

According to a fourth example not forming part of the present invention there is provided a device body portion ("sample") when used in a method according to either the present invention or the first example.

According to a fifth example not forming part of the present invention there is provided a wafer of material including at least one device body portion when used in a method according to either the present invention or the first example.

According to a sixth example not forming part of the present invention there is provided a plasma etching apparatus when used in a method according to the first example. Preferably the sputtering apparatus is a sputterer, which may be a magnetron sputterer.

According to an seventh example not forming part of the present invention there is provided use of a sputtering apparatus in a method according to either the present invention or the first example.

### BRIEF DESCRIPTION OF DRAWINGS

Embodiments of the present invention will now be described, by way of example only, and with reference to the accompanying drawings, which are:
- Figure 1: a side view of a device body portion, as grown, for use in a method of manufacture of an optical device according to an embodiment of the present invention;
- Figure 2: a side view of an optical device according to an embodiment of the present invention manufactured from the device body portion of Figure 1;
- Figure 3: a schematic view of band-gap energies of a part of the device body portion of Figure 1 the part comprising a core layer including a Quantum Well (QW) therein;
- Figure 4: a schematic view similar to Figure 3 of band-gap energies of a corresponding part of the optical device of Figure 2 when Quantum Well Intermixed (QWI);
- Figures 5: (a) to (g) a series of schematic side views of a device body portion during various steps of a method of manufacture of the optical device of Figure 2;
- Figure 6: a simplified schematic representation of a magnetron sputterer apparatus suitable for use in the method of manufacturing Figures (a) to (g);
- Figure 7: a more detailed schematic representation of the magnetron sputterer Figure 6;
- Figures 8: (a) and (b) more detailed schematic side views of the device body portion of Figures 5 (a) to (g) before and after an annealing step shown in Figure 5(g); and
- Figures 9: (a) to (c) schematic representations of various possible configurations of the magnetron sputterer apparatus of Figure 6.

### DETAILED DESCRIPTION OF DRAWINGS

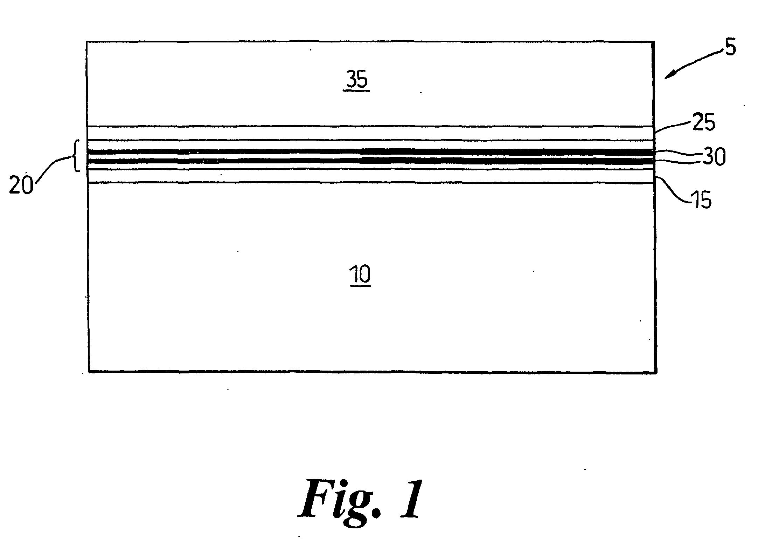

Referring initially to Figure 1, there is shown a device body portion, generally designated 5, as grown, for use in a method of manufacture of an optical device according to a first embodiment of the present invention. The optical device is an integrated optical device or an optoelectronic device.

The device body portion 5 is suitably fabricated in a III-V semiconductor material system, most preferably such as Gallium Arsenide (GaAs), and operating at a wavelength(s) of substantially between 600 and 1300 nm, or alternatively, though less preferably, Indium Phosphide (InP), and operating at a wavelength(s) of substantially between 1200 and 1700 nm. The device body portion 5 may be made at least partly from Aluminium Gallium Arsenide (AlGaAs) and/or Indium Gallium Arsenide (InGaAs), Indium Gallium Arsenide Phosphide (InGaAsP), Indium Aluminium Gallium Arsenide (InGaAlAs) and/or Indium Gallium Aluminium Phosphide (InGaAlP). In this described first embodiment, the device body portion is made from AlGaAs.

The device body portion 5 may form part of a semiconductor wafer together with a plurality of other possibly like optical devices which may be cleaved from the wafer after processing. The device body portion 5 comprises substrate 10 upon which is provided a first optical cladding layer 15, a core guiding layer 20, and a second optical cladding layer 25. A Quantum Well (QW) structure 30, including at least one Quantum Well, is provided within the core guiding layer 20, as grown. On the second optical cladding layer 30 there is provided a capping layer 35.

As will be appreciated, the core guiding layer 20, as grown, has a smaller band-gap and higher refractive index than the first and second optical cladding layer 15,25.

In particular, the process described herein is optimised for use in conjunction with an InGaAs-InAlGaAs-InP material emitting at 1450 to 1550 nm, the structure of which is defined in the table below:

| Layer | Fig 1 ref | Material | Comp. % | Comp range % | Thickness (nm) | Thickness Range (nm) | Dopant | Dopant Conc.(cm³) | Dopant conc. range |
|---|---|---|---|---|---|---|---|---|---|
| Substrate | 10 | InP | - | - | 3500 | 3000-5000 | n(Si) | 1e18 | 1-8e18 |
| 1^{st} Opt cladding | 15 | InP | - | - | 500 | 500-2500 | n(Si) | 8e17 | 1e17-8e18 |
| Core Guiding | 20 | InAlGaAs | 53% In, | 53% In | 210 | 100-400 | i | - | - |
| | | | 31 % Ga | 0-35 % | | | | | |
| | | | 16% Al | 15-47% | | | | | |
| QW | 30 | InGaAs | 53% In | 45-70% | 7 | 3-10 | i | - | - |
| 2^{nd} Opt. Cladding | 25 | InP | - | - | 2100 | 1000-2500 | p(Zn) | 7e17 | 1e17-1e19 |
| Cap | 35 | InGaAs | 53% In | - | 150 | 100-300 | p(Zn) | 2e19 | 5e18-1e20 |

The parameters above refer to MOVPE-grown material of preferred thickness, and preferred thickness range. In InGaAs-InGaAsP-InP material, the core guiding layer 20 InAIGaAs is replaced with InGaAsP with similar properties, ie. band gap. For MBE-grown material the p-type dopant becomes Be while other parameters can remain the same.

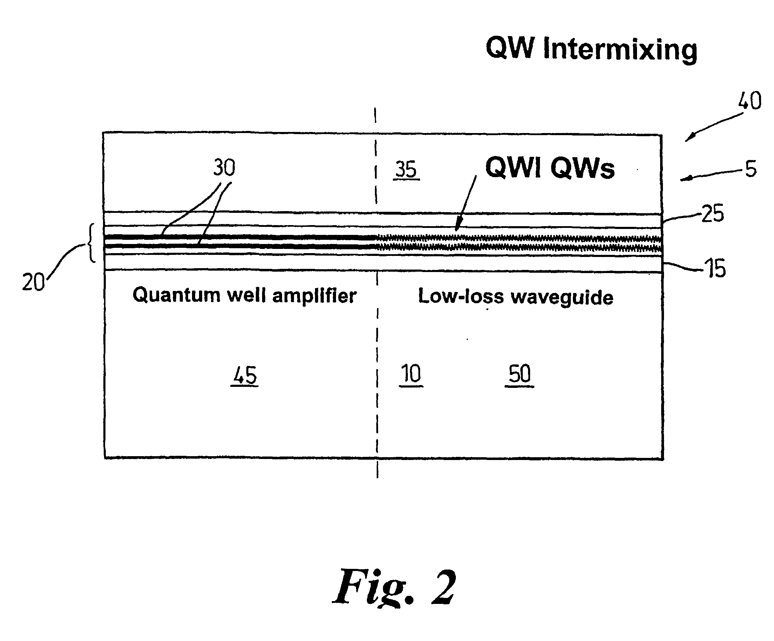

Referring now to Figure 2, there is shown an optical device, generally designated 40, manufactured from the device body portion 5 of Figure 1, by a method which will be described in detail hereinafter. As can be seen from Figure 2, the device 40 comprises an active region 45 and a passive region 50. In this embodiment the active region 45 comprises a Quantum Well (QW) amplifier. However, it should be understood that the active region 45 may in other embodiments, comprise a laser, modulator, switch, detector or like active (electrically controlled) optical device. Further, the passive region 50 comprises a low-loss waveguide wherein the Quantum Well structure 30 has been at least partially removed by a Quantum Well Intermixing (QWI) technique, as will hereinafter be described in greater detail.

The device 40 has excellent alignment between the core layer 20 waveguiding regions of the active region 45 and passive region 50, and has a reflection coefficient between the active region 45 and passive region 50 which is substantially negligible (of the order of 10⁻⁶). Further, mode matching between the active region 45 and the passive region 50 is intrinsic to the device 40.

Typically, the substrate 10 is n-type doped to a first concentration, while the first cladding layer 15 is n-type doped to a second concentration. Further, the core layer 20 is typically substantially intrinsic, while the second cladding layer 25 is typically p-type doped to a third concentration. Further, the cap layer (or contact layer) 35 is p-type doped to a fourth concentration. It will be appreciated by those skilled in the art that the cap layer 35 and second cladding layer 25 may be etched into a ridge (not shown), the ridge acting as an optical waveguide to confine optical modes within the core layer 20 both within the optically active region 45 and the optically passive region 50. Further, contact metallisations (not shown) may be formed on at least a portion of a top surface of the ridge within the optically active region 45, and also on an opposing surface of the substrate 10, as is known in the art.

It will further be appreciated that the device 40 may comprise part of an optical integrated circuit, optoelectronic integrated circuit (OEIC), or photonic integrated circuit (PIC) which may comprise one or more of such optical devices 40.

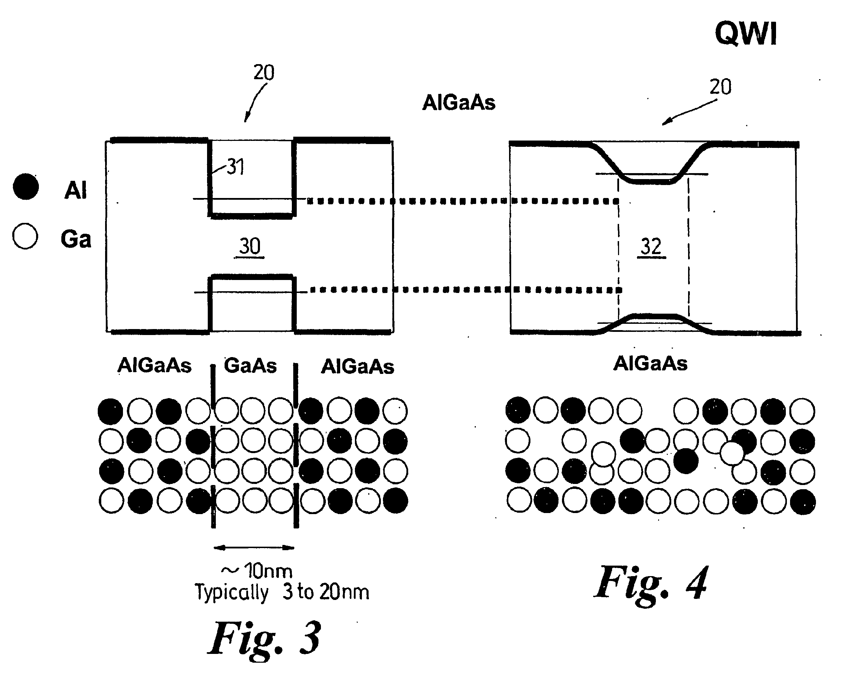

Referring now to Figure 3, there is shown a schematic representation of the band-gap energies of a Quantum Well 31 of the Quantum Well structure 30 within the core layer 20 of the device body portion 5, as grown. As can be seen from Figure 3, the AlGaAs core layer 20 includes at least one Quantum Well 31, with the Quantum Well structure 30 having a lower Aluminium content than the surrounding core layer 20, such that the band-gap energy of the Quantum Well structure 30 is less than that of the surrounding AlGaAs core layer 20. The Quantum Well structure 30 is typically around 3 to 20 nm thick, and more typically around 10 nm in thickness.

Referring now to Figure 4, there is shown a corresponding portion 32 of the core layer 20 as in Figure 3, but which has been Quantum Well Intermixed (QWI) so as to effectively increase the band-gap energy (meV) of the part 32 which corresponds to the Quantum Well 31 of the Quantum Well structure 30. Quantum Well Intermixing (QWI) therefore essentially "washes out" the Quantum Well structure 30 from the core layer 20. The portion shown in Figure 4 relates to the passive region 50 of the device 40. As will be understood, optical radiation transmitted from or generated within the optically active region 45 of device 40 will be transmitted through the low loss waveguide provided by the Quantum Well Intermixed (QWI) region 32 of the core layer 20 of the passive region 50.

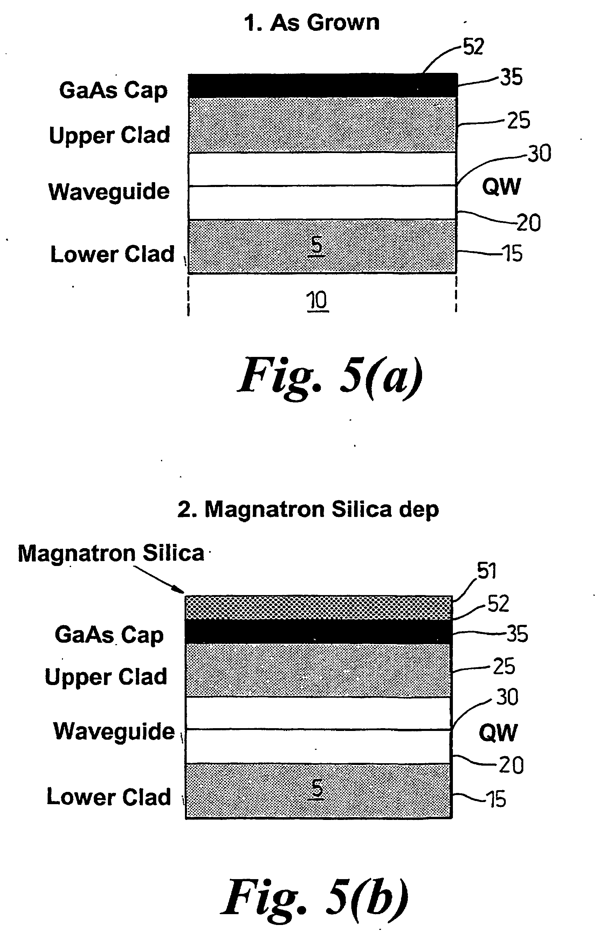

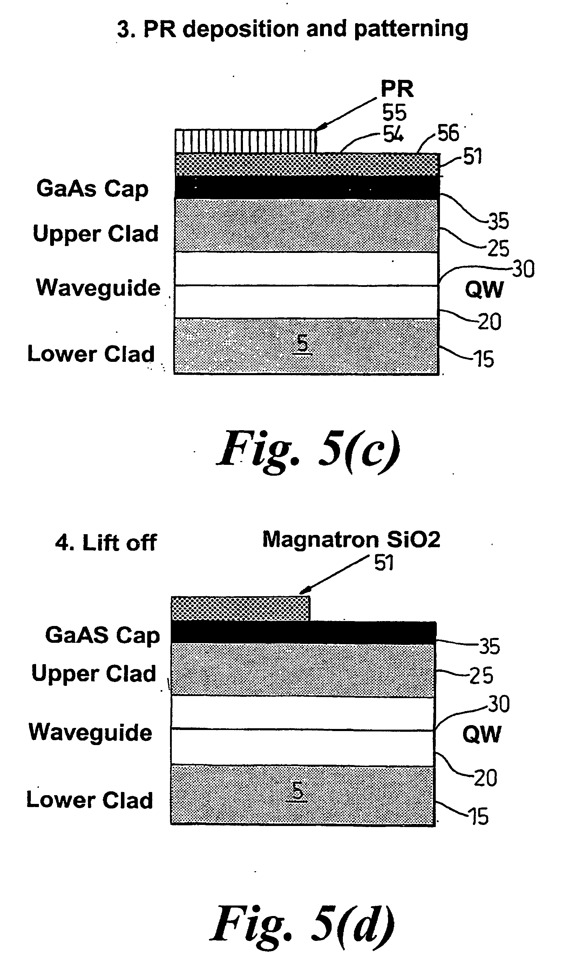

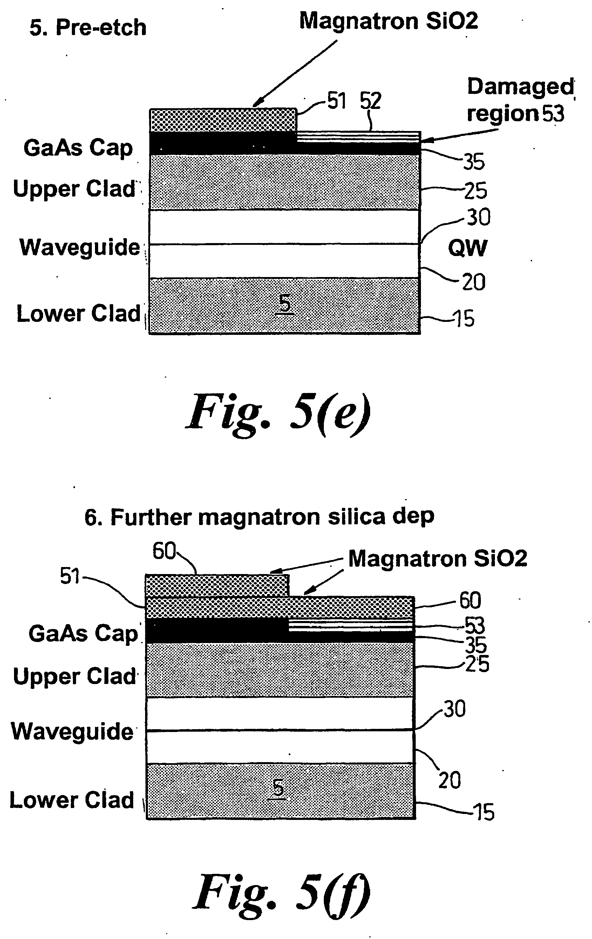

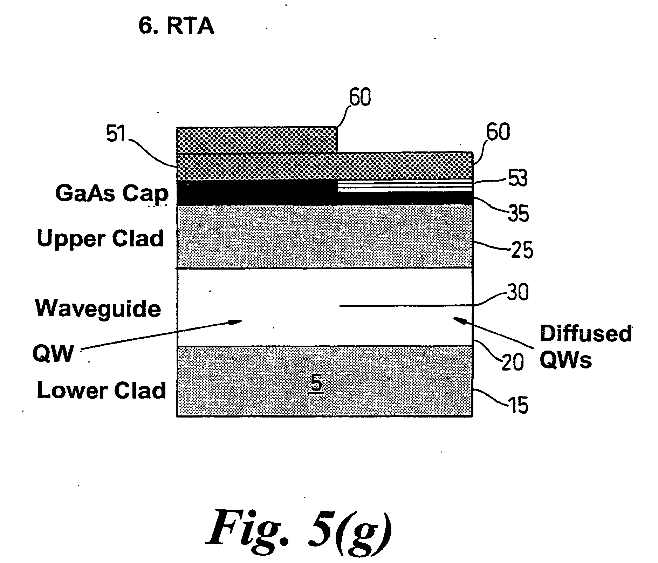

Referring now to Figures 5(a) to (g), there is illustrated a first embodiment of a method of manufacturing an optical device 40 from a device body portion 5, including a Quantum Well (QW) structure 30 according to the present invention, the method including the steps (see Figures 5(d) to (e)) of processing the device body portion 5 so as to create extended defects at least in a portion 53 of the device body portion 5.

The method of manufacture begins (see Figure 5(a) with the step of providing substrate 10, growing on the substrate 10 first optical cladding layer 15, core guiding layer 20 including at least one Quantum Well (QW) 30, second optical cladding layer 25, and cap layer 35.

The first optical cladding layer 15, core guiding layer 20, second optical cladding layer 25, and cap layer 35 may be grown by known semiconductor epitaxial growth techniques such as Molecular Beam Epitaxy (MBE) or Metal Organic Chemical Vapour Deposition (MOCVD).

Once the device of body 5 has been grown - normally as part of a wafer (not shown) including a plurality of such device body portions 5, a dielectric layer 51 is deposited on a surface 52 of the cap layer 35 (see Figure 5(b). A pattern is then defined in Photoresist (PR) 55 on a surface 54 of the dielectric layer 51. The Photoresist 55 is then lifted off so as to leave at least one portion 56 of the dielectric layer 51 exposed (see Figure 5(c)).

Referring to Figure 5(d), the Photoresist 55 and at the least one portion 56 of the dielectric layer 51 are then removed by known etching techniques, eg wet or dry etching. In the case of wet etching Hydrofluoric (HF) acid may be employed.

Referring to Figure 5(e), the device body portion 5 is processed so as to create extended defects at least in a portion 53 of the device body portion 5. The step of processing the device body portion 5 comprises performing a plasma etch on the device body portion 5 using a sputterer 65 as will hereinafter be described in greater detail. This step may be referred to as a "pre-etch", and involves reversing the conventional electrical bias voltage configuration of the sputterer 65.

Referring to Figure 5(f), a further dielectric layer 60 is then deposited on the dielectric layer 51 and on the at least one portion 53 of the device body portion 5. The dielectric layer 51 and further dielectric layer 60 are deposited by use of the sputterer 65. In a modification the dielectric layer 51 and/or the further dielectric layer 60 may be deposited by a deposition technique other than by the use of a sputterer, eg Plasma Enhanced Chemical Vapour Disposition (PECVD).

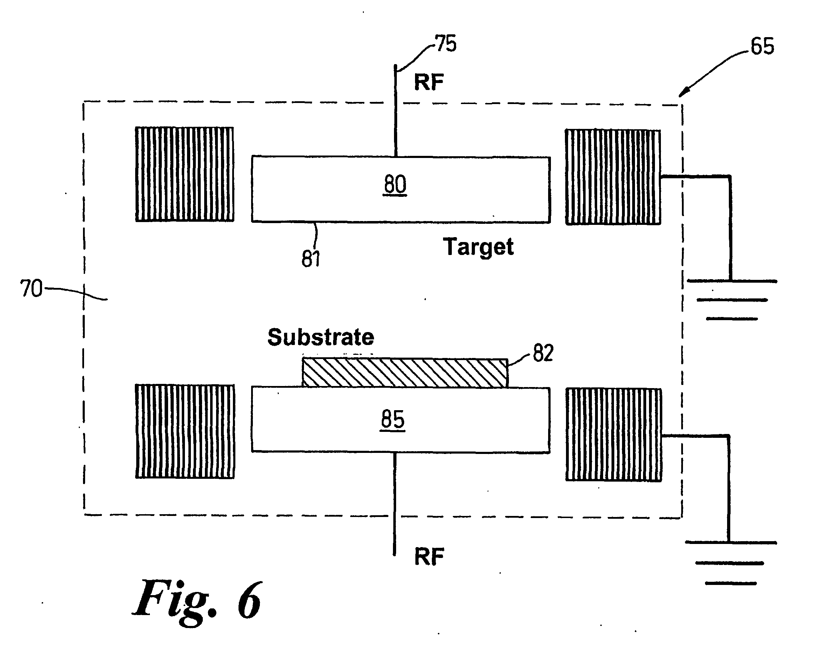

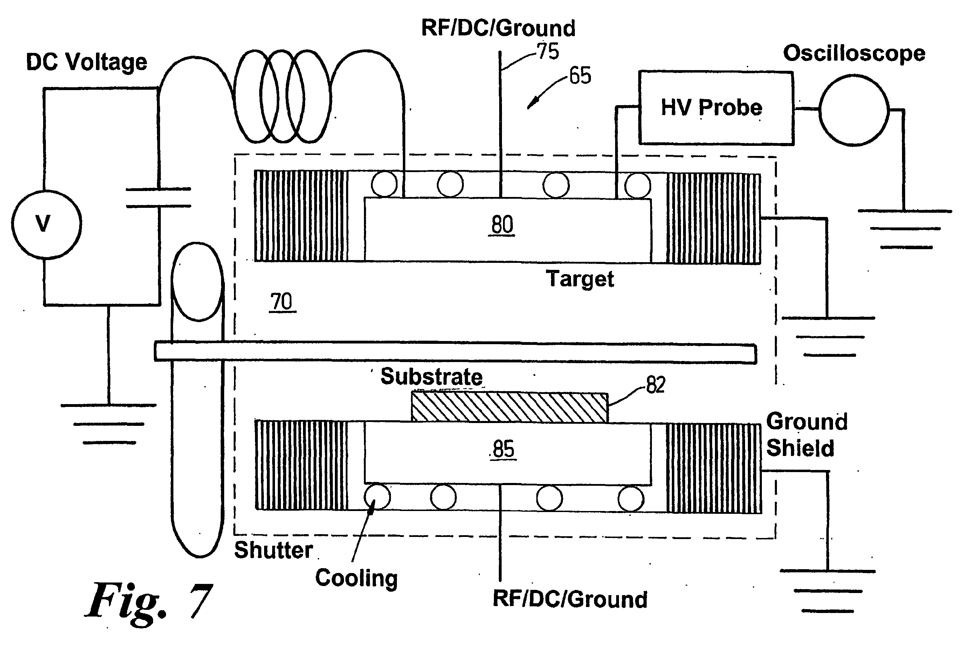

Referring briefly to Figures 6 and 7, the dielectric layer 51 is deposited by sputtering, and in this embodiment the dielectric layer 51 is deposited by sputtering using a magnetron sputterer apparatus, generally designated 65. The dielectric layer 51 substantially comprises Silica (SiO₂), but may in a modification comprise another dielectric material such as Aluminium Oxide (Al₂O₃).

As can be seen from Figure 6, the sputterer apparatus 65 includes a chamber 70 which, in use, is substantially filled with an inert gas such as argon which is preferably provided within the chamber 70 at a pressure of around 2 microns of Hg (0.3 Pa). The sputterer 65 also comprises an RF source 75 connected to a target electrode 80 and to a substrate electrode 85 of the sputterer 65 respectively. A silica target 81 is provided on the target electrode 80, while the device body portion 5 (on wafer 82) is provided on the substrate electrode 85 of the sputterer 65. In use, an argon plasma (not shown) is generated between the target electrode 80 and substrate electrode 85 with first and second dark spaces being provided between the Silica target 81 and the argon plasma and between the argon plasma and the device body portion 5, respectively.

The step of processing the device body portion 5 so as to create extended defects at least in a portion of the device body portion 5 comprises part of a Quantum Well Intermixing (QWI) process used in the manufacture of the device 40, the QWI process comprising - in a preferred embodiment - an Impurity-Free Vacancy Disordering (IFVD) technique. It has been surprisingly found that by sputtering from the device body portion 5 using the sputterer 65, damage induced extended defects appear to be introduced into the portion 53 of the device body portion 5; the portion 53 in this case comprising part of the cap layer 35. It is believed that the damage in the cap layer 35 prior to annealing (which will hereinafter be described), eg the application of thermal energy by rapid thermal annealing, inhibits transfer of Gallium from the portion 53 of the cap layer 35 into the further dielectric layer 60.

The dielectric layer 51 is preferably between 10 to 1000 nm, and typically 200 nm or 300 nm, in thickness. The method of manufacture includes a further step as shown in Figure 5(f) of depositing a further dielectric layer 60 on the surface 52 of device body 5 and on a surface of the dielectric layer 51 prior to annealing. The further dielectric layer 60 may be deposited by a technique other than sputtering, e.g. by Plasma Enhanced Chemical Vapour Deposition (PECVD).

The dielectric layer 51 therefore comprises an intermix cap layer, while the further dielectric layer 60 comprises an intermix suppressing cap layer. The intermix suppressing cap layer is used to protect the surface 52 from Arsenic desorption. The method will work without the intermix suppressing cap layer; however the quality of the surface 52 may not be so good.

As shown in Figure 5(g), subsequent to deposition of the further dielectric layer 60, the device body portion including the dielectric layer 51 and further dielectric layer 60 is annealed at an elevated temperature. The annealing stage comprises a rapid thermal annealing stage, the annealing temperature being between 700 and 1000°C, and more preferably between 800 and 1000°C, for between 0.5 to 5 minutes. In a preferred implementation, the rapid thermal anneal is approximately 900°C for approximately 1 minute.

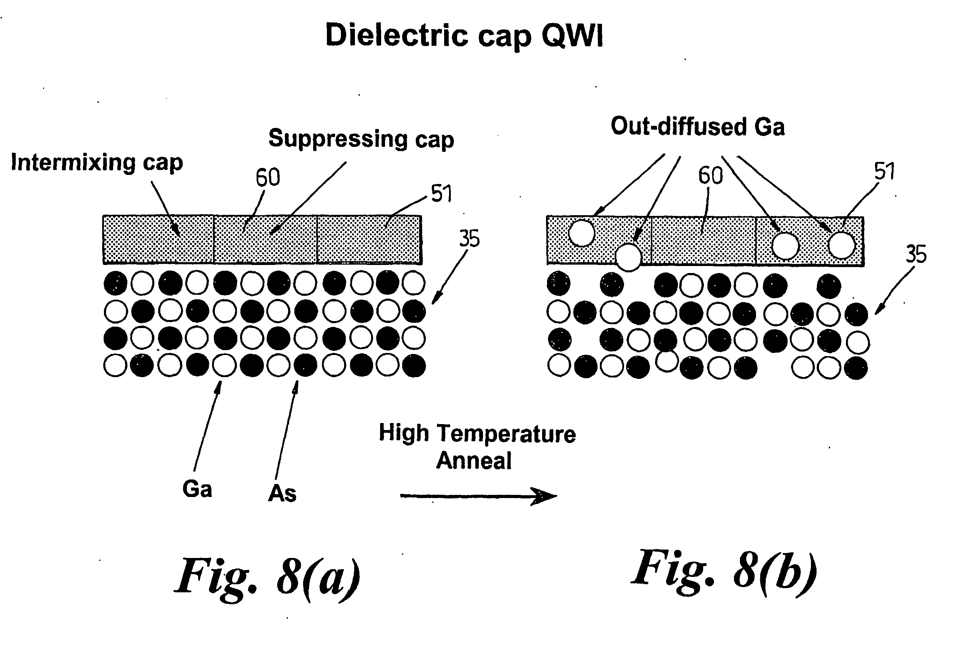

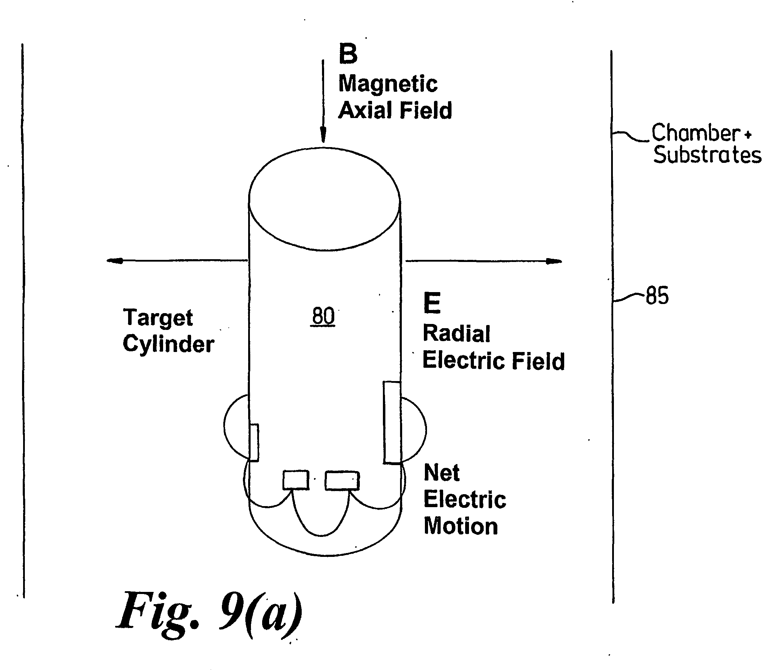

The action of the annealing step of Figure 5(g) is illustrated diagrammatically in Figures 8(a) and (b). As can be seen from Figures 8(a) and (b), the annealing step causes "out diffusion" of Gallium from the cap layer 35 to the intermixing cap, ie dielectric layer 51. However, portions of the cap layer 35 below portion 53 and the suppressing cap, ie further dielectric layer 60, are subject to significantly less Gallium "out-diffusion". The portions of the cap layer 35 which lie within an area of the intermixing cap, ie dielectric cap 51, are subject to greater out-diffusion of Gallium as shown in Figure 8(b). The out-diffusion of Gallium leaves vacancies behind which migrate from the cap layer 35, through the second cladding layer 25, and into the core layer 20, and hence to the Quantum Well structure(s) 30, thereby changing the effective band-gap of the Quantum Well (QW) structure 30, and effectively washing-out the Quantum Wells of the Quantum Well structure 30 below the intermixing cap layer.

It will be appreciated that the intermixing cap, ie dielectric layer 51, is provided within the area of the passive region 50 to be formed in device 40, while the suppressing cap, ie further dielectric layer 60, is provided on the device body portion 5 in areas such as the optically active region 45 to be formed on the device 5, which areas are not to be Quantum Well Intermixed (QWI).

Once the device body portion 5 has been processed to the stage of Figure 5(g), and annealed, the dielectric layer 51 and further dielectric layer 60 may be removed by conventional methods, eg wet or dry etching.

It will be appreciated that in the step of processing the device body portion 5 so as to produce extended defects at least in a portion 53 of the device body portion 5, any sputtering apparatus may be employed. Particularly magnetron sputterers such as the magnetron sputterer 65 illustrated in Figures 6 and 7 can be used.

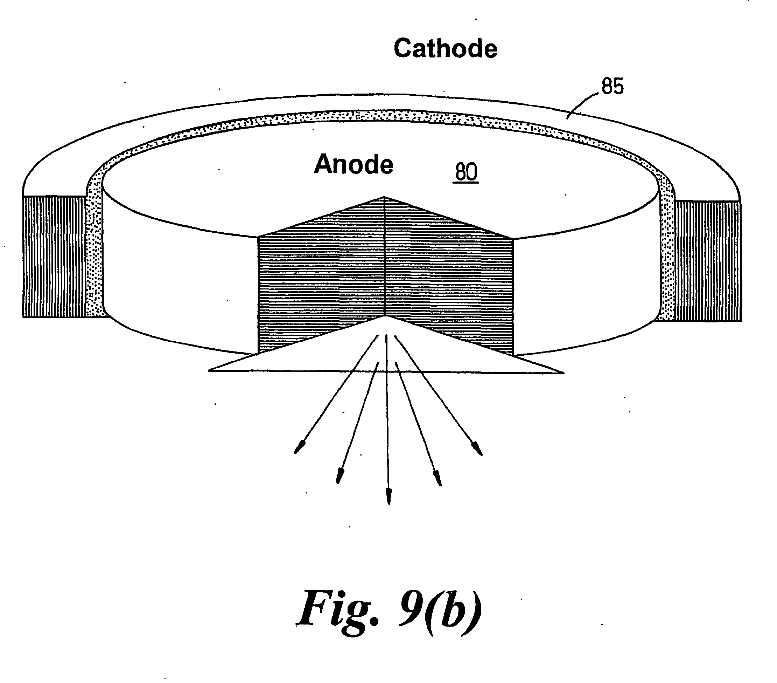

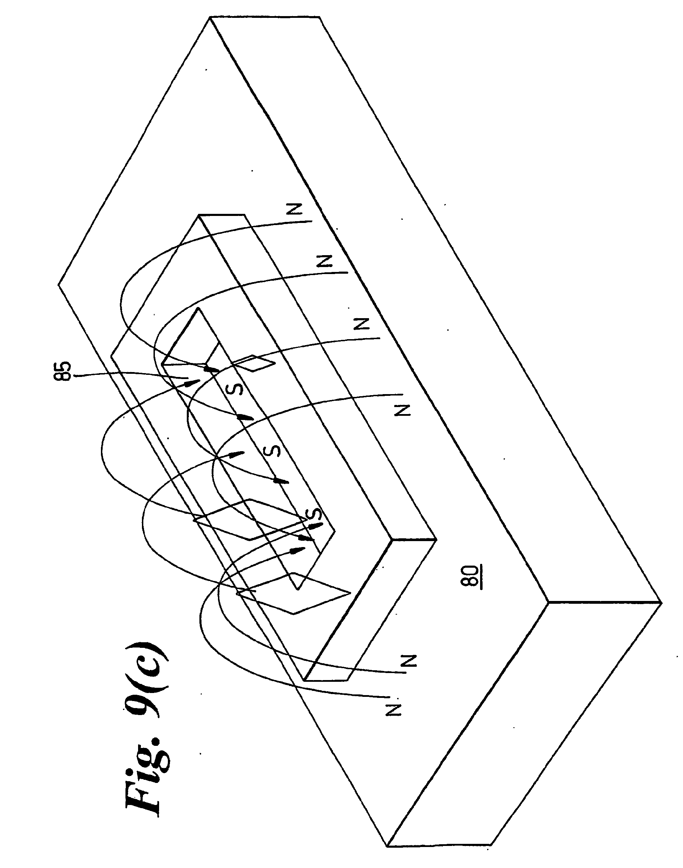

In magnetron sputterers it is attempted to trap electrons near the "target" so as to increase their ionising effect. This is achieved with electric and magnetic fields which are generally perpendicular. It will be appreciated that a number of magnetron sputterer configurations are known such as the cylindrical magnetron illustrated in Figure 9(a), the circular magnetron illustrated in Figure 9(b), or the planar magnetron illustrated in Figure 9(c). The various parts of the magnetron sputterer apparatus 65 a, b, c of Figures 9 a, b, c, respectively are identified by the same reference integers as the magnetron apparatus 65 of Figures 6 and 7.

It will be appreciated that in the step of Figure 5(b) the device body portion 5 comprises the substrate 82 of the sputtering apparatus 65 of Figures 6 and 7, while the silica target 81 is the target from which silica deposition occurs. This is also the case in the deposition stage of the further dielectric layer 60 of Figure 5(f). However, in the step of Figure 5(e) the bias voltages are reversed, and the wafer 82 in effect becomes the sputtering target from which sputtering occurs. This so-called "pre-etch" stage appears to introduce the extended defects into the portion 53 of the device body portion 5. Between the step Figure 5(e) and Figure 5(f), the bias voltages are again reversed.

### EXAMPLE

There now follows an example which illustrates a typical band-gap shift which can be obtained using IFVD in a method of manufacturing an optoelectronic device according to the present invention in an aluminium alloy such as Aluminium Gallium Arsenide (AlGaAs), grown on a Gallium Arsenide (GaAs) substrate.

The sputter chamber 70 is configured as follows. A plate separation of the order of 70 to 100 mm between the target electrode and the substrate electrode is provided, preferably 70 mm. The electrode configuration is a 4 or 8 inch (100 or 200 mm) circular plate, preferably 8 inch (200 mm). The gas used in the system is typically argon but other gases may be used. Also a small amount of oxygen may be added to the plasma (approximately 10% by volume) to improve the stoichiometry when performing dielectric film deposition. The dielectric used for the process is typically SiO₂, but others such as Al₂O₃ can be used. The pressure used within the chamber 70 for both the pre-etch and the silica deposition process is around 2 microns of Hg (0.3 Pa).

The following table outlines the resulting shifts for samples with 200 nm of sputtered silica deposited on top of them. One sample had a 5 minute pre-etch at power level of 500 W. The figures in the Table detailing the shift are for an anneal at 900°C for 1 minute.

**TABLE 1**

| | |
|---|---|
| Deposition conditions | Shift |
| Only sputtered Silica | 45 nm |
| Sputter-etched then encapsulated with sputtered silica | 2 nm |

Table 1 illustrates that performing a sputter etch on the device body portion prior to silica (SiO₂) encapsulation provides an improved intermix suppressing cap.

To process a wafer to produce more than one band gap a film of sputtered or PECVD silica is deposited on to the wafer. Photolithography techniques are then used to delineate a pattern on top the sputtered silica and either wet or dry etching can then be used to transfer the pattern into the sputtered silica.

The sample is then placed into the sputtering apparatus (rig) for pre-etching and a subsequent further sputtered silica deposition.

A rapid thermal anneal is now performed at a suitable temperature (700°C - 1000°C, and more preferably 800°C - 1000°C) for the required period of time (0.5 to 5 min). This enables the point defects generated at the surface in the magnetron silica to propagate through the structure and cause interdiffusion of the elements.

It will be appreciated that the embodiments of the invention hereinbefore described are given by way of example only, and are not meant to limit the scope thereof in any way.

It should be particularly understood that sputtered silica is suitable for performing the IFVD process in around 980 nm GaAs/AlGaAs material. Furthermore, using a combination of a sputter pre-etch and sputtering to deposit another silica layer, provides an effective QWI suppression layer.

It is believed that using the pre-etch causes high levels of damage and the occurrence of extended defects in the cap (top layer) layer of the epitaxial wafer. These extended defects effectively trap point defects and stop them from diffusing down to the QW, thus effectively stopping any intermixing of the QW. The damage arises from the bombardment of ions at the sample surface.

In the sputtering arrangement used for the process the substrate can be switched from being the anode / cathode of the system. Initially, the electrode on which the sample is located (the "substrate electrode") is made negative and the positive ions in the plasma are accelerated to the surface thereof causing a high degree of damage to the cap layer, (ie the extended defects).

Further, it will be appreciated that using effectively the same type of silica for the whole process circumvents a problem of IFVD with dielectric caps, namely mismatch of the expansion of coefficients thereof. This allows the post anneal quality of the material to be kept to a high quality.

It will further be appreciated that an optical device manufactured according to the present invention may include a waveguide such as a ridge or buried heterostructure or indeed any other suitable waveguide.

It will also be appreciated that the Quantum Well Intermixed (QWI) regions may comprise optically active device(s).

Further, it will be appreciated that sequential processing including using several RF powers may be used to provide a device with several different QWI band-gaps.

## Claims

1. A method of manufacturing an optical device (40), a device body portion from which the device is to be made including a Quantum Well QW structure (30), the method being **characterised by** the step of processing the device body portion by performing a plasma etch thereon so as to create extended defects (53) at least in a portion (56) of the device body portion as a step in a Quantum Well Intermixing technique prior to a subsequent thermal annealing step.

2. The method of claim 1 wherein in said step of performing a plasma etch on the device body portion comprises performing a sputter-etch on the device body portion.

3. The method of claim 2 wherein in said step of performing a sputter-etch comprises using a magnetron sputterer (65).

4. The method of claim 2 or claim 3 wherein in said step of performing a sputter-etching on the device body portion includes applying a reverse electrical bias across an electrode (85) upon which the device body portion is provided so as to provide a pre-etch of the device body portion.

5. The method of any preceding claim, wherein the method includes the preceding step of depositing a dielectric layer (51) on at least one other portion of the device body portion, which dielectric layer may therefore act as a mask in defining the at least one portion.

6. The method of claim 6 further including the subsequent step of depositing a further dielectric layer (60) on the dielectric layer (51) and/or on the at least one portion (56) of the device body portion.

7. The method of claim 6 wherein the dielectric layer (51) and/or the further dielectric layer (60) are deposited by use of a sputterer (65).

8. The method of claim 6 wherein the dielectric layer (51) and/or the further dielectric layer (60) are deposited by a deposition technique other than by use of a sputterer.

9. The method of any of claims 6 to 8 wherein the dielectric layer (51) and the further dielectric layer (60) substantially comprise Silica or Aluminium Oxide.

10. The method of any of claims 2 to 4, 7 or 9 wherein the sputterer (65) includes a chamber (70) which is substantially filled with an inert gas.

11. The method of any of claims 5 to 9 wherein the step of depositing the dielectric layer (51, 60) comprises part of a Quantum Well Intermixing (QWI) process used in manufacture of the device.

12. The method of claim 11 wherein the QWI process comprises Impurity-Free Vacancy Disordering.

13. The method of any preceding claim further including the step of annealing the device body portion at an elevated temperature.

14. The method of any preceding claim further including the preceding steps of:
providing a substrate (10, 82);
growing on the substrate:
a first optical cladding layer (15);
a core guiding layer (20) including a Quantum Well structure (30); and
a second optical cladding layer (25).

15. The method claim 14 wherein the first optical cladding layer, core guiding layer, and second optical cladding layer are grown by a growth technique selected from Molecular Beam Epitaxy and Metal Organic Chemical Vapour Deposition.

16. The method of any of claims 5 to 9 further comprising the steps of:
depositing the dielectric layer (51) on a surface of the device body portion; and
defining a pattern in photoresist (55) on a surface (54) of the dielectric layer (51) and lifting off at least part of the photoresist so as to provide the dielectric layer on said at least one other portion of the device body portion.

17. The method of any of claims 6 to 9 wherein the method also includes the step of depositing the further dielectric layer (60) on a portion of the surface of the device body and on a surface (54) of the dielectric layer (51) prior to annealing.

18. The method of any of claims 6 to 9 wherein the dielectric layer (51) comprises an intermixing cap; while the at least one portion of the device body portion and/or the further dielectric layer (60) comprises an intermixing suppressing cap.

19. The method of any of Claims 6 to 9 wherein the thickness of the dielectric layer (51) and the further dielectric layer (60) is between 10 and 1000 nm.

20. The method of claim 14 wherein the annealing step occurs at a temperature of between 800°C and 1000°C for between 0.5 and 5 minutes.

21. The method of any of claims 1 to 20 in which the device body portion is formed from an InGaAs-InAlGaAs-InP system adapted to operate at at least one wavelength between 1450 and 1550 nm.

22. The method of any of claims 1 to 20 including the steps of forming the device body portion from a system comprising any one or more of the following layers: a substrate of InP; a first optical cladding layer of InP, a core guiding layer of InAlGaAs and/or InGaAsP; a quantum well of InGaAs; a second optical cladding layer of InP; and a cap of InGaAs.

## Revendications

1. Procédé de fabrication d'un dispositif optique (40), une partie de corps du dispositif à partir de laquelle le dispositif est fabriqué comprenant une structure à puits quantique QW (30), le procédé étant **caractérisé par** l'étape consistant à traiter la partie de corps du dispositif en effectuant à une gravure plasma sur celle-ci de manière à créer des défauts étendus (53) au moins dans une partie (56) de la partie de corps du dispositif sous la forme d'une étape dans une technique d'interdiffusion de puits quantiques ("Quantum Well Intermixing Technique") (QWI) avant une étape subséquente de recuit thermique.

2. Procédé selon la revendication 1, dans lequel ladite étape consistant à effectuer une gravure plasma sur la partie de corps du dispositif comprend le fait d'effectuer une gravure ionique sur la partie de corps du dispositif.

3. Procédé selon la revendication 2, dans lequel ladite étape consistant à effectuer une gravure ionique comprend l'utilisation d'un pulvérisateur à magnétron (65).

4. Procédé selon la revendication 2 ou la revendication 3, dans lequel ladite étape consistant à effectuer à une gravure ionique sur la partie de corps du dispositif comprend l'application d'une polarisation électrique inverse à travers une électrode (85) sur laquelle la partie de corps du dispositif est placée de manière à procéder à une gravure préliminaire de la partie de corps du dispositif.

5. Procédé selon l'une quelconque des revendications préalable, dans lequel le procédé comprend l'étape préalable consistant à déposer une couche diélectrique (51) sur au moins une autre partie de la partie de corps du dispositif, laquelle couche diélectrique peut ainsi agir comme masque dans la définition de ladite au moins une partie.

6. Procédé selon la revendication 6 comprenant en outre l'étape subséquente consistant à déposer une autre couche diélectrique (60) sur la couche diélectrique (51) et/ou sur ladite au moins une partie (56) de la partie de corps du dispositif.

7. Procédé selon la revendication 6, dans lequel la couche diélectrique (51) et/ou l'autre couche diélectrique (60) sont déposées à l'aide d'un pulvérisateur (65).

8. Procédé selon la revendication 6, dans lequel la couche diélectrique (51) et/ou l'autre couche diélectrique (60) sont déposées par une technique de dépôt autre que par l'utilisation d'un pulvérisateur.

9. Procédé selon l'une quelconque des revendications 6 à 8, dans lequel la couche diélectrique (51) et l'autre couche diélectrique (60) comprennent substantiellement de la silice ou de l'oxyde d'aluminium.

10. Procédé selon l'une quelconque des revendications 2 à 4, 7 ou 9, dans lequel le pulvérisateur (65) comprend une chambre (70) qui est substantiellement remplie d'un gaz inerte.

11. Procédé selon l'une quelconque des revendications 5 à 9, dans lequel l'étape consistant à déposer la couche diélectrique (51, 60) comprend une partie d'un procédé d'interdiffusion de puits quantiques (QWI) utilisé dans la fabrication du dispositif.

12. Procédé selon la revendication 11, dans lequel le procédé QWI comprend une création de désordre de lacune sans impureté ("Impurity-Free Vacancy Disordering").

13. Procédé selon l'une quelconque des revendications précédentes comprenant en outre l'étape consistant à recuire la partie de corps du dispositif à une température élevée.

14. Procédé selon l'une quelconque des revendications précédentes comprenant en outre les étapes préalables consistant à :
fournir un substrat (10, 82) ;
faire croître sur le substrat :
une première couche de gaine optique (15) ;
une couche de guidage de coeur (20) comprenant une structure à puits quantique (30) ; et
une seconde couche de gaine optique (25).

15. Procédé selon la revendication 14, dans lequel la première couche de gaine optique, la couche de guidage de coeur et la seconde couche de gaine optique sont déposées par une technique de croissance choisie parmi l'épitaxie par jets moléculaires et le dépôt chimique en phase vapeur d'organos métalliques.

16. Procédé selon l'une quelconque des revendications 5 à 9 comprenant en outre les étapes consistant à :
déposer la couche diélectrique (51) sur une surface de la partie de corps du dispositif ; et
définir un motif en résine photosensible (55) sur une surface (54) de la couche diélectrique (51) et enlever au moins une partie de la résine photosensible de manière à fournir la couche diélectrique sur ladite au moins une autre partie de la partie de corps du dispositif.

17. Procédé selon l'une quelconque des revendications 6 à 9, dans lequel le procédé comprend l'étape consistant à déposer l'autre couche diélectrique (60) sur une partie de la surface de corps du dispositif et sur une surface (54) de la couche diélectrique (51) avant le recuit.

18. Procédé selon l'une quelconque des revendications 6 à 9, dans lequel la couche diélectrique (51) comprend une coiffe d'interdiffusion ; tandis que la au moins une partie de la partie de corps du dispositif et/ou l'autre couche diélectrique (60) comprend une coiffe de suppression d'interdiffusion.

19. Procédé selon l'une quelconque des revendications 6 à 9, dans lequel l'épaisseur de la couche diélectrique (51) et de l'autre couche diélectrique (60) est comprise entre 10 et 1000 nm.

20. Procédé selon la revendication 14, dans lequel l'étape de recuit se produit à une température comprise entre 800 °C et 1000 °C pendant une durée de 0,5 à 5 minutes.

21. Procédé selon l'une quelconque des revendications 1 à 20, dans lequel la partie de corps du dispositif est formée à partir d'un système InGaAs-InAlGaAs-InP adapté pour fonctionner à au moins une longueur d'onde comprise entre 1450 et 1550 nm.

22. Procédé selon l'une quelconque des revendications 1 à 20 comprenant les étapes consistant à former la partie de corps du dispositif à partir d'un système comprenant l'une quelconque ou plusieurs des couches suivantes : un substrat d'InP ; une première couche de gaine optique d'InP, une couche de guidage de coeur d'InAlGaAs et/ou d'InGaAsP ; un puits quantique d'InGaAs ; une seconde couche de gaine optique d'InP ; et une coiffe d'InGaAs.

## Patentansprüche

1. Verfahren zur Herstellung einer optischen Vorrichtung (40), wobei ein Vorrichtungskörperabschnitt, aus dem die Vorrichtung herzustellen ist, eine Quantenmuldenstruktur (QM-Struktur) 30 enthält, wobei das Verfahren **gekennzeichnet ist durch** den Schritt des Verarbeitens des Vorrichtungskörperabschnitts mittels Durchführen einer Plasmaätzung auf dem Vorrichtungskörperabschnitt zum Zweck des Ausbildens ausgedehnter Defekte (53) wenigstens in einem Abschnitt (56) des Vorrichtungskörperabschnitts als ein Schritt in einer Quantenmuldenvermischungstechnik vor einem anschließenden Schritt des thermischen Ausheilens.

2. Verfahren nach Anspruch 1, wobei der Schritt des Durchführens einer Plasmaätzung auf dem Vorrichtungskörperabschnitt das Durchführen einer Sputterätzung auf dem Vorrichtungskörperabschnitt umfasst.

3. Verfahren nach Anspruch 2, wobei der Schritt des Durchführens einer Sputterätzung das Verwenden einer Magnetron-Sputtervorrichtung (65) umfasst.

4. Verfahren nach Anspruch 2 oder Anspruch 3, wobei der Schritt des Durchführens einer Sputterätzung auf dem Vorrichtungskörperabschnitt das Anlegen einer umgekehrten elektrischen Vorspannung an eine Elektrode (85), auf welcher der Vorrichtungskörperabschnitt angeordnet ist, beinhaltet, so dass eine Vorätzung auf dem Vorrichtungskörperabschnitt stattfindet.

5. Verfahren nach einem der vorangehenden Ansprüche, wobei das Verfahren den vorangehenden Schritt des Abscheidens einer dielektrischen Schicht (51) auf wenigstens einem anderen Abschnitt des Vorrichtungskörperabschnitts beinhaltet, wobei die dielektrische Schicht darum als eine Maske bei der Definierung des wenigstens einen Abschnitts fungieren kann.

6. Verfahren nach Anspruch 6, das des Weiteren den anschließenden Schritt des Abscheidens einer weiteren dielektrischen Schicht (60) auf der dielektrischen Schicht (51) und/oder auf dem wenigstens einen Abschnitt (56) des Vorrichtungskörperabschnitts beinhaltet.

7. Verfahren nach Anspruch 6, wobei die dielektrische Schicht (51) und/oder die weitere dielektrische Schicht (60) mittels einer Sputtervorrichtung (65) abgeschieden werden.

8. Verfahren nach Anspruch 6, wobei die dielektrische Schicht (51) und/oder die weitere dielektrische Schicht (60) mittels einer anderen Abscheidungstechnik als mittels einer Sputtervorrichtung abgeschieden werden.

9. Verfahren nach einem der Ansprüche 6 bis 8, wobei die dielektrische Schicht (51) und die weitere dielektrische Schicht (60) im Wesentlichen Siliciumdioxid oder Aluminiumoxid umfassen.

10. Verfahren nach einem der Ansprüche 2 bis 4, 7 oder 9, wobei die Sputtervorrichtung (65) eine Kammer (70) enthält, die im Wesentlichen mit einem inerten Gas gefüllt ist.

11. Verfahren nach einem der Ansprüche 5 bis 9, wobei der Schritt des Abscheidens der dielektrischen Schicht (51, 60) einen Teil eines Quantenmuldenvermischungsverfahrens (QMV-Verfahrens) umfasst, das für die Herstellung der Vorrichtung verwendet wird.

12. Verfahren nach Anspruch 11, wobei das QMV-Verfahren das Durchführen einer störatomfreien Leerstellen-Fehlordnung umfasst.

13. Verfahren nach einem der vorangehenden Ansprüche, das des Weiteren den Schritt des Ausheilens des Vorrichtungskörperabschnitts bei einer erhöhten Temperatur umfasst.

14. Verfahren nach einem der vorangehenden Ansprüche, das des Weiteren folgende vorangehende Schritte beinhaltet:
Bereitstellen eines Substrats;
Aufwachsen auf dem Substrat:
einer ersten optischen Überzugsschicht (15);
einer Kernführungsschicht (20), die eine Quantenmuldenstruktur (30) enthält; und
einer zweiten optischen Überzugsschicht (25).

15. Verfahren nach Anspruch 14, wobei die erste optische Überzugsschicht, die Kernführungsschicht und die zweite optische Überzugsschicht mittels einer Aufwachstechnik aufgewachsen werden, die unter Molekularstrahlepitaxie (MSE) und metall-organischer chemischer Dampfabscheidung (MOCDA) ausgewählt ist.

16. Verfahren nach einem der Ansprüche 5 bis 9, das des Weiteren folgende Schritte umfasst:
Abscheiden der dielektrischen Schicht (51) auf einer Oberfläche des Vorrichtungskörperabschnitts; und
Ausbilden einer Photoresist-Struktur (55) auf einer Oberfläche der dielektrischen Schicht (51) und Abheben wenigstens eines Teils des Photoresists, so dass die dielektrische Schicht auf dem wenigstens einen anderen Abschnitt des Vorrichtungskörperabschnitts hergestellt wird.

17. Verfahren nach einem der Ansprüche 6 bis 9, wobei das Verfahren des Weiteren den Schritt des Abscheidens der weiteren dielektrischen Schicht (60) auf einem Abschnitt der Oberfläche des Vorrichtungskörpers und auf einer Oberfläche (54) der dielektrischen Schicht (51) vor dem Ausheilen beinhalten.

18. Verfahren nach einem der Ansprüche 6 bis 9, wobei die dielektrische Schicht (51) eine Vermischungskappe umfasst, während der wenigstens eine Abschnitt des Vorrichtungskörperabschnitts und/oder die weitere dielektrische Schicht (60) eine Vermischungsunterdrückungskappe umfasst.

19. Verfahren nach einem der Ansprüche 6 bis 9, wobei die Dicke der dielektrischen Schicht (51) und der weiteren dielektrischen Schicht (60) zwischen 10 und 1000 nm beträgt.

20. Verfahren nach Anspruch 14, wobei der Ausheilungsschritt bei einer Temperatur zwischen 800°C und 1000°C bei einer Dauer zwischen 0,5 und 5 Minuten stattfindet.

21. Verfahren nach einem der Ansprüche 1 bis 20, wobei der Vorrichtungskörperabschnitt aus einem InGaAs-InAlGaAs-InP-System hergestellt ist, das dafür geeignet ist, bei wenigstens einer Wellenlänge zwischen 1450 und 1550 nm zu arbeiten.

22. Verfahren nach einem der Ansprüche 1 bis 20, das den Schritt des Ausbildens des Vorrichtungskörperabschnitts aus einem System beinhaltet, das eine oder mehrere der folgenden Schichten umfasst: ein Substrat aus InP; eine erste optische Überzugsschicht aus InP, eine Kernführungsschicht aus InAlGaAs und/oder InGaAsP; eine Quantenmulde aus InGaAs; eine zweite optische Überzugsschicht aus InP; und eine Kappe aus InGaAs.
